Europäisches Patentamt

European Patent Office

Office européen des brevets

(19)

(11) Veröffentlichungsnummer: **0 187 791**
**B1**

(12) **EUROPÄISCHE PATENTSCHRIFT**

(45) Veröffentlichungstag der Patentschrift:
**26.10.88**

(21) Anmeldenummer: **85903272.4**

(22) Anmeldetag: **04.07.85**

(86) Internationale Anmeldenummer:
**PCT/EP 85/00323**

(87) Internationale Veröffentlichungsnummer:
**WO 86/00937 (13.02.86 Gazette 86/4)**

(51) Int. Cl.⁴: **C 23 C 14/06**

(54) **VERFAHREN ZUR HERSTELLUNG VON HOCHVERSCHLEISSFESTEN TITANNITRID-SCHICHTEN.**

(30) Priorität: **20.07.84 DE 3426795**

(43) Veröffentlichungstag der Anmeldung:
**23.07.86 Patentblatt 86/30**

(45) Bekanntmachung des Hinweises auf die Patenterteilung:
**26.10.88 Patentblatt 88/43**

(84) Benannte Vertragsstaaten:
**AT CH DE FR GB IT LI**

(56) Entgegenhaltungen:
FR - A - 2 107 126

Thin Solid Films, vol. 107, no. 2, September 1983,Lausanne (CH) W.D. Sproul:"Very high rate reactive sputtering of TIN, ZrN, HrN", pages 141-147, see page 142: "Experimental apparatus and procedures"
Journal of Nuclear Materials, no. 103 & 104, 1981 K. Sato et al.: "Preparation of titanium nitride onto molybdenum, stainless steel and carbon by gas absorption and reactive RF sputtering", pages 273-278, see page 274, left-hand column
Metalloberfläche, vol 37, no. 7, July 1983, München (DE) W.D. Muenz et al.: "Herstellung harter dekorativer goldfarbener Titannitridschichten mittels Hochleistungskathodenzerstäubung", pages 279-285, see pages 281-283, figures 6,15

(73) Patentinhaber: **Battelle-Institut e.V., Am Römerhof 35 Postfach 900 160, D-6000 Frankfurt/Main 90 (DE)**

(72) Erfinder: **STEININGER, Helmut, Schumannstrasse 12, D-6392 Neu-Anspach (DE)**
Erfinder: **ETZKORN, Heinz-Werner, Schumannstrasse 16, D-6392 Neu-Anspach (DE)**

(74) Vertreter: **Sartorius, Peter, Dipl.-Ing., Battelle-Institut e.V. Abteilung Patente Am Römerhof 35, D-6000 Frankfurt am Main 90 (DE)**

(56) Entgegenhaltungen: (Fortsetzung)
Thin Solid Films, vol. 96, no. 1, October 1982, Lausanne (CH) W.D. Münz et al.: "A high rate sputtering process for the formation of hard frictionreducing TIN coatings on tools", pages 79-86, see pages 82,85
Thin Solid Films, vol.111, no. 4, January 1984, Lausanne (CH) B.O. Johansson et al.: "Influence of substrate shape on TIN films prepared by reactive sputtering", pages 313-322, see page 315: "Experimental procedure"
Thin Solid Films, vol. 107, No. 2, September 1983, Lausanne (CH) M.K. Hibbs et al.: "The microstructure of reactively sputtered Ti-N films", pages 149-157, see page 150: Experimental procedure"
Chemical Abstracts, vol. 101, no. 26, 24 December 1984, Columbus, Ohio (US) U. Hemersson et al.: "Adhesion of reactively sputtered titanium nitride (TIN) on different tool and high-speed steels", see page 198, abstract 233894p

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Herstellung von hochverschleissfesten Titannitrid-Schichten durch Magnetron-Sputtern in einer Vakuum-Beschichtungsanlage unter Verwendung von Stickstoff und einem Edelgas als Prozessgas und einem Titantarget.

Titannitrid-Schichten werden auf Maschinenteilen und Werkzeugen bestehend aus reinen Metallen oder Legierungen aufgebracht, um eine Steigerung der Standmengen und -zeiten sowie Schnittgeschwindigkeiten von Schneidwekzeugen zu erzielen. Die Beschichtung wird im allgemeinen nach CVD-Techniken oder durch bekannte physikalische Beschichtungsverfahren wie Magnetron-Sputtern oder Ionenplattieren durchgeführt. Beim Magnetron-Sputtern werden übliche Verfahrensbedingungen eingehalten; z.B. beträgt der Restgasdruck ca. 1 x 10⁻⁴ bis 1 x 10⁻³ Pa, die Beschichtung wird normalerweise bei Drücken in der Grössenordnung von etwa 1 Pa vorgenommen. Typischerweise werden Beschichtungstemperaturen von mehr als ca. 450° C verwendet.

Bei den nach den bekannten Methoden mit Titannitrid beschichteten Werkzeugen wird eine Leistungssteigerung gegenüber unbeschichteten Werkzeugen um einen Faktor 3 bis 12 angegeben. Diese Werte stimmen gut mit in der Literatur zu findenden Verschleissminderungen von TiN beschichteten Werkstücken überein, die auf Kugel (Stift)-Scheibe-Tribometern ermittelt wurden. (H.M. Gabriel, Proc. Verschleiss und Korrosionsschutz durch ionen- und plasmagestützte Vakuumbeschichtungstechnologien, S. 37, Darmstadt 1983; V. Demarne, E. Bergmann, Proc. dito, S. 269, Darmstadt 1983).

Der Erfindung liegt die Aufgabe zugrunde, die verschleissmindernde Wirkung von Titannitrid beschichteten Werkstücken wesentlich zu erhöhen.

Diese Aufgabe ist erfindungsgemäss dadurch gelöst, dass die Beschichtungsanlage auf einen Restgasdruck in der Grössenordnung von weniger als etwa 1 x 10⁻⁴ Pa evakuiert wird und dass Stickstoff und Edelgas mit einer Reinheit von mindestens 99,999 % verwendet werden, wobei eine Verunreinigung der Gase bei der Zuführung ausgeschlossen wird, und dass das zu beschichtende Substrat nasschemisch und durch Sputterätzen und das Titantarget durch Sputterätzen gereinigt werden und das an das Substrat eine Biasspannung von 50 bis 250 V angelegt wird. Vorteilhafte Ausführungsformen des erfindungsgemässen Verfahrens sind in den Unteransprüchen 2 bis 8 beschrieben.

Vor dem Hintergrund der bisher erzielten und dargelegten Erfolge mit Titannitrid-Beschichtungen zur Verschleissminderung ist es überraschend, dass es mit Hilfe des an sich bekannten Magnetron-Sputterns bei geeigneter Prozessführung möglich ist, im Kugel-Scheibe-Experiment eine Leistungssteigerung gegenüber unbeschichteten Reibpaarungen um mindestens einen Faktor 35 bis 70 zu erreichen. Ebenso überraschend ist es, dass die geringste Abweichung von den erfindungsgemässen Massnahmen wesentliche Änderungen in dem Verschleissverhalten der Schichten mit sich zieht.

Das überraschende Ergebnis des erfindungsgemässen Verfahrens ist im wesentlichen auf die folgenden Massnahmen zurückzuführen:

– Die Beschichtungsanlage wird auf einen Restgasdruck in der Grössenordnung von weniger als etwa 1 x 10⁻⁴ Pa evakuiert. Die Beschichtung selbst wird unter einem Druck in der Grössenordnung von etwa 1 x 10⁻¹ Pa oder geringer durchgeführt.

– Es werden reinste Gase Stickstoff und Edelgas, vorzugsweise Argon, mit einem Reinheitsgrad von 5N verwendet.

– Es wird dafür gesorgt, dass eine Verunreinigung der Gase bei der Gaszuführung ausgeschlossen ist. Dies geschieht z.B. dadurch, dass bei der Auslegung des Gaseinlassystems Ultrahochvakuum-Technologien angewendet werden, wie Einsatz von Edelstahlrohren, Ganzmetallverschraubungen aus Edelstahl usw. Die Dichtheit des Gaseinlasssystems wird ausserdem massenspektrometrisch mit Helium geprüft.

– Das zu beschichtende Substrat wird nasschemisch und durch Sputterätzen gereinigt. Ebenso wird das Titantarget durch Sputterätzen gereinigt.

– An das zu beschichtende Substrat wird eine Biasspannung von 50 bis 250 V, vorzugsweise 100 V, angelegt.

Ferner:

– Argon und Stickstoff werden mit einer konstanten Durchflussrate zugeführt. Die Durchflussrate des Argons beträgt 8 bis 15 cm³/Min, vorzugsweise 10,5 bis 13,5 cm³/Min, des Stickstoffs 2 bis 15 cm³/Min, vorzugsweise 3 bis 7 cm³/Min.

– Die Abscheiderate bei der Beschichtung beträgt 10 bis 35 Å/s, vorzugsweise 25 bis 30 Å/s.

Das zu beschichtende Substrat wird auf etwa 100 bis 300 °C vorzugsweise 120 bis 200 °C vorgewärmt, d. h. es werden verglichen mit dem Stand der Technik wesentlich niedrigere Substrattemperaturen benutzt. Dadurch ist es möglich, z. B. fast alle Stahlsorten zu beschichten, ohne dass die Grundhärte reduziert wird.

Die Vorreinigung des Substrats, das aus Metallen, Legierungen, geeigneten Kunststoffen, z.B. faserverstärkten Kunststoffen, oder keramischen Materialien bestehen kann, geschieht erfindungsgemäss durch eine Lösungsmittel-Reinigung im Ultraschallbad, der sich eine Endreinigung durch Plasmaätzen in der Beschichtungsanlage anschliesst. Die Plasmaätzung des Substrats erfolgt z.B. unter Argon-Atmosphäre. Daran kann sich unmittelbar der eigentliche Beschichtungsprozess anschliessen. Das Titantarget wird ebenfalls während der Endreinigung des Werkstücks durch Sputterätzen gereinigt.

Die Erfindung wird im folgenden Beispiel näher beschrieben.

**Beispiel**

Ein Werkstück aus Kugellagerstahl (100 Cr 6) wurde im Ultraschallbad gründlich in mehreren Stufen mit organischen Lösungsmitteln gereinigt und zwar mit Trichlorethylen, Aceton und Isopropanol. Anschliessend wurde das Werkstück unter reinster Luft getrocknet. Danach wurde das Substrat in der Beschichtungsanlage durch Sputterätzen unter reinster Argon-Atmosphäre einer Endreinigung unterzogen. Das Titantarget wurde während der Endreinigung des Substrats ebenfalls durch Sputterätzen gereinigt.

Das Substrat wurde auf 200 °C vorgewärmt. Die Beschichtung erfolgte bei einem Restgasdruck von kleiner als $1 \times 10^{-3}$ Pa durch reaktives Magnetron-Sputtern in einer Argon/Stickstoff-Atmosphäre. Die Argondurchflussrate betrug 10,5 bis 13,5 cm$^3$/Min, der Stickstoffdurchfluss 3 bis 5 cm$^3$/Min. Die Reinheitsstufen der verwendeten Gase, die über Edelstahlrohre in die Beschichtungsanlage geleitet wurden, betrug 5 N. Die höchste Reinheit der eingelassenen Gase wurde sichergestellt durch die konsequente Anwendung von Ultrahochvakuum-Technologien im Bereich des gesamten Gaseinlasssystems. Während der Beschichtung wurde an das Substrat eine Biasspannung von 100 V angelegt. Titannitrid wurde mit einer Ahbscheiderate von 25 bis 30 Å/s abgeschieden. Die Schichtdicke betrug 5 μm.

Die Härte der erfindungsgemäss hergestellten Titannitrid-Schichten liegt zwischen 2200 und 3500 HV$_{0,1}$. Die mit einer Auger-Mikrosonde untersuchten Titannitrid-Schichten und das Interface zwischen Schicht und Substrat sind frei von Verunreinigungen wie Sauerstoff und Kohlenstoff.

Der im Kugel-Scheibe-Tribometer ermittelte Verschleiss an erfindungsgemäss hergesellten Titannitrid-Schichten ist gegenüber unbeschichteten Teilen um einen Faktor 35 bis 70 reduziert.

**Patentansprüche**

1. Verfahren zur Herstellung von hochverschleissfesten Titannitrid-Schichten durch Magnetron-Sputtern in einer Vakuum-Beschichtungsanlage unter Verwendung von Stickstoff und einem Edelgas als Prozessgas und einem Titantarget, dadurch gekennzeichnet, dass die Beschichtungsanlage auf einen Restgasdruck in der Grössenordnung von weniger als etwa $1 \times 10^{-4}$ Pa evakuiert wird und dass Stickstoff und Edelgas mit einer Reinheit von mindestens 99,999 % verwendet werden, wobei eine Verunreinigung der Gase bei der Zuführung ausgeschlossen wird, und dass das zu beschichtende Substrat nasschemisch und durch Sputterätzen und das Titantarget durch Sputterätzen gereinigt werden und dass an das Substrat eine Biasspannung von 50 bis 250 V angelegt wird.

2. Verfahren nach Anspruch 1, dadurch gekennzeichnet, dass bei der Auslegung des Gaseinlasssystems zur Verhinderung der Verunreinigung der Gase Ultrahochvakuum-Technologien angewendet werden.

3. Verfahren nach Anspruch 1 oder 2 dadurch gekennzeichnet, dass die Beschichtung unter einem Druck in der Grössenordnung von etwa $1 \times 10^{-1}$ Pa oder geringer durchgeführt wird.

4. Verfahren nach einem der Ansprüche 1 bis 3, dadurch gekennzeichnet, dass an das Substrat eine Biasspannung von 100 V angelegt wird.

5. Verfahren nach einem der Ansprüche 1 bis 4, dadurch gekennzeichnet, dass Stickstoff und Edelgas, vorzugsweise Argon, mit einer konstanten Durchflussrate zugeführt werden.

6. Verfahren nach einem der Ansprüche 1 bis 5, dadurch gekennzeichnet, dass die Durchflussrate des Argons 8 bis 15 cm$^3$/Min, vorzugsweise 10,5 bis 13,5 cm$^3$/Min, des Stickstoffs 2 bis 15 cm$^3$/Min, vorzugsweise 3 bis 7 cm$^3$/Min beträgt.

7. Verfahren nach einem der Ansprüche 1 bis 6, dadurch gekennzeichnet, dass das Substrat auf 100 bis 300 °C, vorzugsweise 120 bis 250 °C vorgewärmt wird.

8. Verfahren nach einem der Ansprüche 1 bis 7, dadurch gekennzeichnet, dass die Abscheiderate 10 bis 35 Å/s, vorzugsweise 25 bis 30 Å/s beträgt.

**Revendications**

1. Méthode de production de revêtements de nitrure de Titane, hautement résistants à l'usure par crépitement au magnetron dans une unité de revêtement sous vide, utilisant de l'azote et un gaz rare comme gaz de transformation et une cible en Titane caractérisée en ce qu'elle comprend la purge de l'unité de revêtement à une pression résiduelle de gaz de l'ordre de moins de $1,10^{-4}$ Pa environ et en ce qu'elle utilise de l'azote et un gaz rare à une pureté d'au moins 99,999%, la contamination des gaz pendant l'introduction étant exclue:

— le nettoyage du substrat à recouvrir par voie humide par un procédé chimique ainsi que par décapage par crépitement,

— le nettoyage de la cible de Titane par décapage par crépitement,

— et l'application d'un voltage de dérivation de 50 à 250 V au substrat.

2. Une méthode comme revendiqué dans la revendication 1 caractérisée en ce que les technologies du vide extrêmement poussé ont été appliquées dans la construction du système d'entrée du gaz, de façon à prévenir la contamination des gaz.

3. Une méthode comme revendiqué dans les revendications 1 ou 2 caractérisée en ce que le revêtement est effectué à une pression de l'ordre de $1,10^{-1}$ Pa environ, ou moins.

4. Une méthode comme revendiqué dans chacune des revendications 1 à 3 caractérisée en ce qu'un voltage de dérivation de 100 V est appliqué au substrat.

5. Une méthode comme revendiqué dans chacune des revendications 1 à 4 caractérisée en ce que l'azote et le gaz rare, de préférence de l'Argon, sont introduits à un débit constant.

6. Une méthode comme revendiqué dans chacune des revendications 1 à 5 caractérisée en ce que la vitesse de débit de l'Aron est de 8 à 15 cm$^3$/mn, de préférence 10,5 à 13,5 cm$^3$/mn et la vitesse de débit de l'azote est de 2 à 15 cm$^3$/mn, de préférence de 3 à 7 cm$^3$/mn.

7. Une méthode comme revendiqué dans chacune des revendications 1 à 6, caractérisée en ce que le substrat est pré-chauffé à 100 à 300 °C, de préférence de 100 à 250 °C.

8. Une méthode comme revendiqué dans chacune des revendications 1 à 7 caractérisée en ce que le taux de déposition est de 1 à 35 Å/s, de préférence de 25 à 30 Å/s.

## Claims

1. Method of producing highly wear-resistant-titanium nitride coatings by magnetron sputtering in a vacuum coating unit using nitrogen and noble gas as process gas and a titanium target, comprising: evacuating the coating unit to a residual gas pressure of the order of less than about $1 \times 10^{-4}$ Pa and using nitrogen and noble gas in a purity of at least 99.999%, contamination of the gases during introduction being excluded, and cleaning the substrate to be coated by a wet chemical process and by sputter etching and the titanium target by sputter etching, and applying a bias voltage of 50 to 250 V to the substrate.

2. Method as claimed in Claim 1, wherein ultra-highvacuum technologies are being applied in the construction of the gas inlet system in order to prevent contamination of the gases.

3. Method as claimed in Claim 1 or Claim 2, wherein coating is effected at a pressure of the order of about $1 \times 10^{-1}$ Pa or less.

4. Method as claimed in any of the Claims 1 to 3, wherein a bias voltage of 100 V is applied to the substrate.

5. Method as claimed in any of the Claims 1 to 4, wherein nitrogen and noble gas, preferably argon, are introduced at a constant flow rate.

6. Method as claimed in any of the Claims 1 to 5, wherein the flow rate of argon is 8 to 15 cm$^3$/min, preferably 10,5 to 13,5 cm$^3$/min, and the flow rate of nitrogen is 2 to 15 cm$^3$/min, preferably 3 to 7 cm$^3$/min.

7. Method as claimed in any of the Claims 1 to 6, wherein the substrate is preheated to 100 to 300 °C, preferably 120 to 250 °C.

8. Method as claimed in any of the Claims 1 to 7, wherein the deposition rate is 10 to 35 Å/s, preferably 25 to 30 Å/s.